# EUROPEAN PATENT SPECIFICATION

(11) **EP 0 390 313 B1**
(45) Date of publication and mention of the grant of the patent: **01.06.1994**
(21) Application number: 90301272.2
(22) Date of filing: 06.02.1990
(51) Int. Cl.: H01S 3/025, H01S 3/103, H01S 3/043

(54) **A semiconductor laser device**
Halbleiterlaser-Vorrichtung
Dispositif laser à semi-conducteur

(30) Priority: 28.03.1989 JP 77722/89
(43) Date of publication of application: 03.10.1990
(73) Proprietor: MITSUBISHI DENKI KABUSHIKI KAISHA, Tokyo (JP)
(72) Inventor: Hasegawa, Kazuyoshi, c/o Mitsubishi Denki K.K., Itami-shi, Hyogo-ken (JP)
(74) Representative: Beresford, Keith Denis Lewis

(56) References cited:
- PATENT ABSTRACTS OF JAPAN, vol. 13, no. 114 (E-730), 20th March 1989 & JP-A-63-287 085
- PATENT ABSTRACTS OF JAPAN, vol. 10, no. 11 (E-374), 17th January 1986 & JP-A-60-175 476
- PATENT ABSTRACTS OF JAPAN, vol. 7, no. 123 (E-178)[1268], 27th May 1983 & JP-A-58-042 286
- PATENT ABSTRACTS OF JAPAN, vol. 9, no. 27 (E-294)[1750], 6th February 1985 & JP-A-59-172 787
- APPLIED PHYSICS LETTERS, vol. 43, no. 8, October 1983, pages 733-735; H. KOYAMA et al.: "Stress compensation in laser diodes"
- JEE - JOURNAL OF ELECTRONIC ENGINEERING, vol. 24, no. 248, August 1987, pages 54-56, Tokyo, JP; T. YAMAGUCHI: "Monolithic 3-beam semiconductor laser: Now a practical reality"

## Description

### FIELD OF THE INVENTION

The present invention relates to a semiconductor laser device which is used as a light source in such as an optical disk apparatus.

### BACKGROUND OF THE INVENTION

Figure 2 shows a cross-section of a prior art two beam array semiconductor laser (hereinafter referred to as "two beam array LD") device. In figure 2, reference numeral 10 designates a monolithic two beam array LD chip. This two beam array LD chip 10 is bonded onto a silicon submount 11 and a heat sink 12. Reference numeral 5 designates a photodiode as a light receiving element (hereinafter referred to as "monitor PD") for receiving a monitor light from the two beam array LD chip 10. The heat sink 12 and a monitor photodiode 5 are bonded onto a stem 6. Reference numeral 7 designates a cap, and reference numeral 8 designates a window fixed to the cap 7.

This laser device will operate as follows.

Two monitor light emissions which are emitted from the two beam array LD chip 10 are photodetected by the monitor photodiode 5 which is arranged on the stem 6. Then, the light signals are converted into an electric signal by the monitor photodiode 5, and the electric signal is sent out to an APC (Auto Power Control) circuit provided outside the laser device, and thus the light outputs emitted from the front facet of the two beam array LD chip 10 are adjusted.

In the semiconductor laser device of such construction, two monitor light beams emitted from the two beam array LD chip 10 are received by the monitor photodiode 5. Therefore, when the two laser light beams are generated at the same time, the respective laser light beams cannot be APC controlled independently. Furthermore, they are apt to be influenced by thermal and electrical interference.

Figure 3 shows a semiconductor laser device disclosed in Japanese Patent Laid-Open Publication No. Sho 60-175476. In figure 3, reference numeral 14 designates a semiconductor substrate. Reference numeral 13 designates an electrode disposed on the semiconductor substrate 14. Reference numeral 15 designates an insulating region produced at a bottom portion of the substrate 14. The semiconductor substrate 14 is disposed on a heat sink 16. The heat sinks 16 for the respective semiconductor substrates 14 are insulated from each other by an insulator 17. That is, metal as heat sink 16 and the insulator 17 for electrode separation are arranged in a sandwich manner, and semiconductor chips are mounted on the respective heat sinks. In the semiconductor laser device of such construction, it is possible to electrically and thermally separate the semiconductor chips from each other.

Figure 4 shows a semiconductor laser array device disclosed in Japanese Laid-open Patent Publication No. Sho 61-159788. In figure 4, reference numeral 18 designates a semiconductor laser array. Reference numeral 19 designates an n type GaAs heat sink. Reference numeral 20 designates a pn junction photodiode disposed on the heat sink 19. Reference numeral 21 designates an electrode. Reference numeral 22 designates a remaining portion produced by etching required portions of the heat sink 19. Herein, the semiconductor laser array 18 having a plurality of semiconductor laser elements is provided on the heat sink 19, and the pn junction photodiodes 20 are provided just behind the respective semiconductor laser elements on the heat sink 19. The remaining protruding portion 22 is located between the respective photodiodes. In such construction, laser beams emitted from the rear facets of respective semiconductor laser elements are precisely monitored by the photodiodes 20. Furthermore, since there exists a GaAs region 22 protruding between the adjacent photodiodes, the respective laser beams can be monitored independently without thermal and electrical interference.

In the semiconductor laser device disclosed in Sho 60-175476, however, when an LD chip is used as a semiconductor chip, a plurality of LD chips are arranged on the same main surface. Therefore, when the respective laser beams are emitted at the same time and are monitored by a light receiving element (not shown), there arise problems of thermal and electrical interference. Furthermore, it is impossible to APC drive the respective laser beams independently.

In the semiconductor laser array device disclosed in Sho 61-159788, since the respective laser elements are placed on the same surface, a plurality of pn junction photodiodes which monitor the light outputs have to be provided quite close to the laser array even when a GaAs protruding region 22 is provided between the adjacent photodiodes. This results in difficulty in production. Furthermore, since the heat sink comprises GaAs, the heat radiation capacity of the heat sink is poor.

A semiconductor device according to the preamble of claim 1 is disclosed in JP-A-63287085.

### SUMMARY OF THE INVENTION

The semiconductor laser device according to the present invention is defined in claim 1. Embodiments are set out in the dependent claims.

The present invention provides a dual or multielement semiconductor laser device having reduced thermal and electrical interference. The respective elements can be controlled independently.

Advantages of the present invention will become apparent from the detailed description given hereinafter; it should be understood, however, that the detailed description and specific embodiment are given by way of illustration only, since various changes and modifications within the scope of the invention will become apparent to those skilled in the art from this detailed description.

According to the present invention, a semiconductor laser device is provided with a heat sink constructed to have a plurality of element mounting portions each having an element mounting surface, and insulators for electrically separating the respective element mounting portions from each other. A pair of semiconductor laser element and light receiving element are arranged on an element mounting surface while another pair of laser element and light receiving element are arranged on another element mounting surface . Accordingly, the respective laser elements are not subjected to thermal and electrical interference , and the respective laser beams can be individually monitored at high precision. Furthermore, since a light receiving element is provided corresponding to a laser element, independent APC driving is enabled.

### BRIEF DESCRIPTION OF THE DRAWINGS

Figures 1(a) and (b) are a cross-sectional view and a plan view showing a two beam array semiconductor laser device according to a first embodiment of the present invention, respectively;
Figure 2 is a cross-sectional view showing a two beam array semiconductor laser device according to a prior art;
Figure 3 is a perspective view showing a semiconductor laser device according to another prior art;

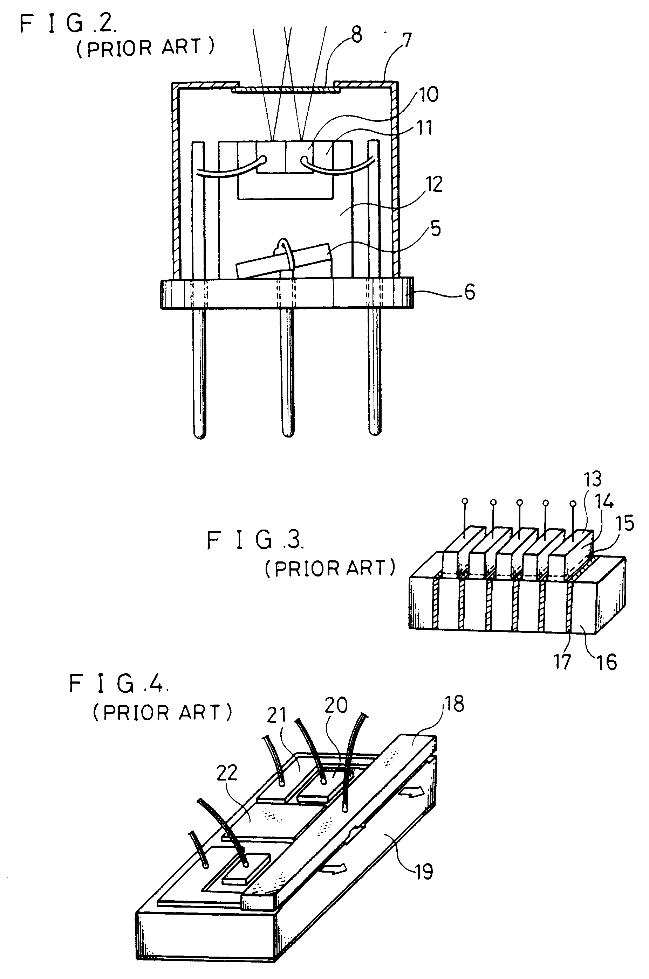

Figure 4 is a perspective view showing a semiconductor laser array device according to still another prior art;
Figure 5 is a diagram showing a brief construction of a three beam array LD according to a second embodiment of the present invention; and
Figure 6 is a diagram showing a brief construction of a four beam array LD according to a third embodiment of the present invention.

### DETAILED DESCRIPTION OF THE PREFERRED EMBODIMENTS

An embodiment of the present invention will be described in detail with reference to the drawings.

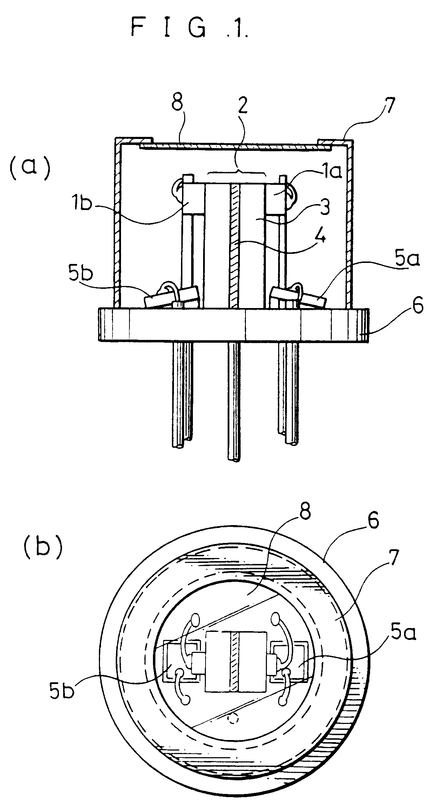

Figure 1 (a) shows a cross-sectional view of a two beam array semiconductor laser device according to a first embodiment of the present invention and figure 1(b) shows a plan view thereof. In figure 1, reference numeral 2 designates a laminated layer heat sink constituted by an insulator 4 comprising alumina having poor thermal conductivity and two element mounting portions 3 comprising silver having good thermal conductivity arranged on each side of the insulator 4. Reference numerals 1a and 1b designate semiconductor laser chips (hereinafter referred to as "laser diode") provided on the element mounting surfaces of the respective element mounting portions 3. Monitor light receiving elements (hereinafter referred to as "photodiode") 5a and 5b are provided at positions below the semiconductor laser chips 1a and 1b. Reference numeral 6 designates a stem for mounting the heat sink 2 and photodiodes 5a and 5b. This stem 6 has five lead terminals. Reference numeral 7 designates a cap. Reference numeral 8 designates a window fixed to the cap 7. APC circuits corresponding to the respective laser diodes 1a and 1b are provided outside the device.

This laser device will operate as follows.

The monitor beams emitted from the laser diodes 1a and 1b are received by the photodiodes 5a and 5b provided at positions below the laser diodes, respectively, thereby generating currents. The currents are sent out to the respective APC circuits provided at outside the device corresponding to the photodiodes 5a and 5b. Herein, the amplitudes of the current and the light output of the laser beams emitted from the front facet of the laser diodes are in a proportional relationship, and the currents generated by the photodiodes 5a and 5b are respectively controlled to be constant by the functions of the respective APC circuits. Thus, the light outputs of the laser beams emitted from the front facets of the laser diodes 1a and 1b are held at constant values.

When the laser diodes 1a and 1b generate light, heat is generated at the neighborhood of the light generation point at the same time. Then, heat is transmitted to the stem 6 from the silver element-mounting portions 3 of laminated heat sink 2. Since the alumina insulator 4 is inserted between the element mounting portions 3, the laser diodes 1a and 1b will not be subjected to thermal and electrical interference, and the respective laser beams can be monitored accurately and independently.

While in the above-illustrated embodiment the laser diodes 1a and 1b are directly put on the heat sink 3, a Si submount for relaxing the thermal stress may be provided therebetween.

While in the above-illustrated embodiment the element mounting portion 3 comprises silver and the insulator 4 comprises alumina, the element mounting portion may comprise copper or iron and the insulator may comprise quartz glass.

In the above-illustrated embodiment a two beam array laser diode is described, but the present invention need not be restricted to a two beam array laser diode.

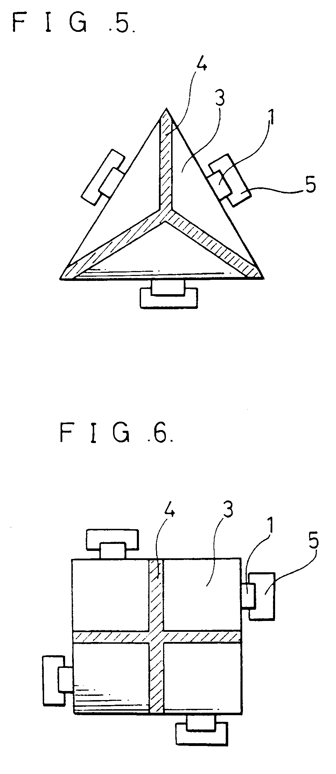

Figure 5 shows a three beam array laser diode according to a second embodiment of the present invention, and figure 6 shows a four beam array laser diode according to a third embodiment of the present invention. In these embodiments, a pair of laser diode 1 and photodiode 5 are mounted on an element mounting surface of the element mounting portion 3, and the respective element mounting portions 3 are thermally and electrically separated by the insulator 4.

## Claims

1. A semiconductor laser device compring:
a heat sink member (3,4) having outwardly facing side-wall surfaces which surfaces lie in respective different planes;
a plurality of semiconductor laser elements (1), each element (1) mounted on a different side-wall surface of said heat sink member (3,4) with said heat sink member (3,4) obscuring each semiconductor laser element (1) from each other; and
a plurality of monitor light receiving elements (5) arranged around said heat sink member (3,4) each located opposite to, and in a monitor light path of, a respective one of said semiconductor laser elements (1);
which device is characterised in that:
said heat sink member (3,4) is divided into discrete element mounting portions (3), each mounting a respective one of said semiconductor laser elements (1), and each portion (3) being electrically separated and thermally insulated from each other portion (3), adjacent thereto, by an insulative partition (4).

2. A semiconductor laser device as defined in claim 1, wherein said element mounting portions (3) of said heat sink (3,4) comprise silver, copper, or iron, and said insulative partitions (4) comprise alumina or quartz glass.

3. A semiconductor laser device as claimed in any one of the preceding claims when combined with control circuit means for controlling light output of each semiconductor laser element (1) independently of each other in accordance with a respective response of each respective monitor light receiving element.

4. A semiconductor laser device as claimed in claim 1 wherein said heat sink member (3,4) is divided into 2, 3 or 4 discrete element mounting portions (3).

## Patentansprüche

1. Halbleiterlaser-Vorrichtung mit:
einem Kühlkörper-Teil (3, 4) mit nach außen liegenden Seitenwandflächen, die in jeweils verschiedenen Ebenen liegen;
einer Vielzahl von Halbleiterlaserelementen (1), wobei jedes Element (1) auf einer anderen Seitenwandfläche des Kühlkörper-Teils (3, 4) befestigt ist, und der Kühlkörper-Teil (3, 4) jedes Halbleiterlaserelement (1) von jedem anderen abschirmt; und
einer Vielzahl von um den Kühlkörper-Teil (3, 4) herum angeordneten Überwachungs-Lichtempfangselementen (5), von denen sich jedes gegenüber von jeweils einem der Halbleiterlaserelemente (1) in dessen Überwachungs-Lichtpfad befindet;
**dadurch gekennzeichnet, daß**
der Kühlkörper-Teil (3, 4) in Befestigungsteilstücke (3) für diskrete Elemente aufgeteilt ist, wobei an jedem jeweils eines der Halbleiterlaserelemente (1) befestigt ist, und wobei jedes Teilstück (3) von jedem anderen benachbarten Teilstück (3) durch eine isolierende Unterteilung (4) elektrisch getrennt und thermisch isoliert ist.

2. Halbleiterlaser-Vorrichtung nach Anspruch 1,
**dadurch gekennzeichnet, daß**
die Element-Befestigungsteilstücke (3) des Kühlkörper-Teils (3, 4) Silber, Kupfer oder Eisen enthalten, und die isolierenden Unterteilungen (4) Aluminium oder Quarzglas enthalten.

3. Halbleiterlaser-Vorrichtung nach einem der vorhergehenden Ansprüche,
**gekennzeichnet durch**
eine Kombination mit einer Steuerschaltungseinrichtung zum voneinander unabhängigen Steuern der Lichtausgabe jedes Halbleiterlaserelements (1) gemäß einer jeweiligen Antwort eines jeden jeweiligen Überwachungs-Lichtempfangselements.

4. Halbleiterlaser-Vorrichtung nach Anspruch 1,
**dadurch gekennzeichnet, daß**
der Kühlkörper-Teil (3, 4) in 2, 3 oder 4 Befestigungsteilstücke (3) für diskrete Elemente aufgeteilt ist.

## Revendications

1. Un dispositif laser à semiconducteurs comprenant :
un radiateur (3, 4) ayant des surfaces de parois latérales faisant face vers l'extérieur, qui s'étendent dans des plans différents respectifs;
un ensemble d'éléments lasers à semiconducteurs (1), chaque élément (1) étant monté sur une surface de paroi latérale différente du radiateur (3, 4), de manière que le radiateur (3, 4) masque chaque élément laser à semiconducteurs (1) par rapport à l'autre; et
un ensemble d'éléments de réception de lumière de contrôle (5) disposés autour du radiateur (3, 4), avec chacun d'eux disposé face à l'un respectif des éléments lasers à semiconducteurs (1), et dans un faisceau de lumière de contrôle de celui-ci;
ce dispositif étant caractérisé en ce que :
le radiateur (3, 4) est divisé en parties de montage d'élément discrètes (3), avec l'un respectif des éléments lasers à semiconducteurs (1) monté sur chacune de ces parties de montage, et chaque partie (3) étant isolée au point de vue électrique et thermique, par rapport à chaque autre partie (3) qui lui est adjacente, par une séparation isolante (4).

2. Un dispositif laser à semiconducteurs défini dans la revendication 1, dans lequel les parties de montage d'élément (3) du radiateur (3, 4) consistent en argent, en cuivre ou en fer, et les séparations isolantes (4) consistent en alumine ou en verre au quartz.

3. Un dispositif laser à semiconducteurs selon l'une quelconque des revendications précédentes lorsqu'il est combiné avec un circuit de commande destiné à commander la puissance lumineuse émise par chaque élément laser à semiconducteurs (1), indépendamment les uns des autres, conformément à une réponse respective de chaque élément de réception de lumière de contrôle respectif.

4. Un dispositif laser à semiconducteurs selon la revendication 1, dans lequel le radiateur (3, 4) est divisé en 2, 3 ou 4 parties de montage d'élément discrètes (3).
